# EUROPEAN PATENT SPECIFICATION

(11) **EP 0 533 519 B1**
(45) Date of publication and mention of the grant of the patent: **24.04.1996**
(21) Application number: 92402344.3
(22) Date of filing: 26.08.1992
(51) Int. Cl.: H01L 39/22, H01L 39/24

(54) **Superconducting device having an extremely thin superconducting channel formed of oxide superconductor material and method for manufacturing the same**
Supraleitende Einrichtung mit extrem dünnen supraleitenden Kanal aus oxydisch supraleitendem Material und Verfahren zu deren Herstellung
Dispositif supraconducteur ayant un canal extrêmement mince, formé en matériau supraconducteur d'oxyde et méthode pour sa fabrication

(30) Priority: 26.08.1991 JP 238689/91; 26.08.1991 JP 238690/91; 07.08.1992 JP 232939/92
(43) Date of publication of application: 24.03.1993
(73) Proprietor: Sumitomo Electric Industries, Ltd., Osaka 541 (JP)
(72) Inventor: Tanaka, So c/o, F-75116 Paris (FR); Iiyama, Michitomo c/o, F-75116 Paris (FR)
(74) Representative: Ballot, Paul Denis Jacques

(56) References cited:
- EP-A- 0 354 804
- EP-A- 0 488 837
- EP-A- 0 505 259

## Description

### Field of the invention

The present invention relates to a superconducting device and a method for manufacturing the same, and more specifically to a superconducting device having an extremely thin superconducting channel formed of oxide superconductor material, and a method for manufacturing the same.

### Description of related art

Devices which utilize superconducting phenomena operate rapidly with low power consumption so that they have higher performance than conventional semiconductor devices. Particularly, by using an oxide superconducting material which has been recently advanced in study, it is possible to produce a superconducting device which operates at relatively high temperature.

Josephson device is one of well-known superconducting devices. However, since Josephson device is a two-terminal device, a logic gate which utilizes Josephson devices becomes complicated. Therefore, three-terminal superconducting devices are more practical.

Typical three-terminal superconducting devices include two types of super-FET (field effect transistor). The first type of the super-FET includes a semiconductor channel, and a superconductor source electrode and a superconductor drain electrode which are formed closely to each other on both side of the semiconductor channel. A portion of the semiconductor layer between the superconductor source electrode and the superconductor drain electrode has a greatly recessed or undercut rear surface so as to have a reduced thickness. In addition, a gate electrode is formed through a gate insulator layer on the portion of the recessed or undercut rear surface of the semiconductor layer between the superconductor source electrode and the superconductor drain electrode.

A superconducting current flows through the semiconductor layer (channel) between the superconductor source electrode and the superconductor drain electrode due to a superconducting proximity effect, and is controlled by an applied gate voltage. This type of the super-FET operates at a higher speed with a low power consumption.

The second type of the super-FET includes a channel of a superconductor formed between a source electrode and a drain electrode, so that a current flowing through the superconducting channel is controlled by a voltage applied to a gate formed above the superconducting channel.

Both of the super-FETs mentioned above are voltage controlled devices which are capable of isolating output signal from input one and of having a well defined gain.

However, since the first type of the super-FET utilizes the superconducting proximity effect, the superconductor source electrode and the superconductor drain electrode have to be positioned within a distance of a few times the coherence length of the superconductor materials of the superconductor source electrode and the superconductor drain electrode. In particular, since an oxide superconductor has a short coherence length, a distance between the superconductor source electrode and the superconductor drain electrode has to be made less than about a few ten nanometers, if the superconductor source electrode and the superconductor drain electrode are formed of the oxide superconductor material. However, it is very difficult to conduct a fine processing such as a fine pattern etching, so as to satisfy the very short separation distance mentioned above.

On the other hand, the super-FET having the superconducting channel has a large current capability, and the fine processing which is required to product the first type of the super-FET is not needed to product this type of super-FET.

In order to obtain a complete ON/OFF operation, both of the superconducting channel and the gate insulating layer should have an extremely thin thickness. For example, the superconducting channel formed of an oxide superconductor material should have a thickness of less than five nanometers, namely about four or five unitcells and the gate insulating layer should have a thickness more than ten nanometers which is sufficient to prevent a tunnel current.

However, one or two unitcells of the both side of the extremely thin superconducting channel formed of the oxide superconductor may not behave as a superconductor. Therefore, the substantial thickness of the superconducting channel becomes thinner than the physical thickness, which in turn the superconducting current through the superconducting channel is reduced than expected.

The surface region of the superconducting channel is constituted of irregular lattices which are produced by the surface instability of the oxide superconductor thin film. After the gate insulating layer is deposited on the oxide superconductor thin film, the irregular lattices are maintained or enhanced. Therefore, the surface region of the superconducting channel may not behave as a superconductor.

The lattice order and stoichiometry of the bottom region of the superconducting channel are distorted because of the thermal expansion discrepancy between the oxide superconductor thin film and the substrate. The oxide superconductor thin film is deposited at a temperature not lower than 500°C so that the lower portion of the oxide superconductor thin film is under stress of the thermal expansion discrepancy between the oxide superconductor thin film and the substrate when it is cooled down to the room temperature.

Additionally, while the oxide superconductor thin film is deposited, constituent atoms of the substrate may defuse into the oxide superconductor thin film so that the lower portion of the oxide superconductor thin film is degraded.

Furthermore, the baned of Cu-O planes at most surface of oxide superconductor layers help to generate the non-superconducting regions.

Therefore, if the superconducting channel is composed of an oxide superconductor thin film having a thickness of about four or five unitcells, superconducting current may flow in a layer having a thickness of only one or two unitcells of the oxide superconductor channels.

The document EP-A-0 354 804 discloses a superconducting device according to the preamble of claim 1.

### Summary of the Invention

Accordingly, it is an object of the present invention to provide an FET type superconducting device having a superconducting region constituted of an extremely thin oxide superconductor film, which have overcome the above mentioned defects of the conventional ones.

Another object of the present invention is to provide a method for manufacturing an FET type superconducting device which have overcome the above mentioned defects of the conventional ones.

The above and other objects of the present invention are achieved in accordance with the present invention by a superconducting device as set forth in claim 1.

The superconducting device in accordance with the present invention may comprise the oxide layer either between the superconducting channel and the gate insulator or between the superconducting channel and the substrate. Of course the superconducting device in accordance with the present invention may comprise both of the oxide layers between the superconducting channel and the gate insulator and between the superconducting channel and the substrate.

Preferably, the oxide layer between the superconducting channel and the substrate is formed of a *c*-axis orientated Pr₁Ba₂Cu₃O_{7-ε} thin film and the oxide layer between the superconducting channel and the gate insulator is formed of a *c*-axis orientated Pr₁Ba₂Cu₃O_{7-ε} thin film, an SrOₓ thin film, a BaOₓ thin film, a KOₓ thin film or a PbOₓ thin film.

These oxide compensate for crystalline incompleteness of both on an upper surface and on a bottom surface of an oxide superconductor thin film. Especially, when the superconducting channel is formed of a *c*-axis orientated oxide superconductor thin film, the oxide layer formed of a *c*-axis orientated Pr₁Ba₂Cu₃O_{7-ε} thin film is favorable. Since the *c*-axis orientated Pr₁Ba₂Cu₃O_{7-ε} thin film has an almost same crystal lattice structure as that of a *c*-axis orientated oxide superconductor thin film.

Therefore, lattice order on the upper or the bottom surfaces of the extremely thin oxide superconductor film which forms the superconducting channel of the superconducting device in accordance with the present invention can be complete enough to conduct the superconducting current even at the near interface region of the channel. Namely, cross-sectional area of the superconducting channel of the superconducting device in accordance with the present invention is substantially larger than that of a conventional superconducting device. With this, the superconducting device in accordance with the present invention has a larger current capability than a conventional one. In case of the superconducting device in accordance with the present invention which includes both of the oxide layers between the superconducting channel and the gate insulator and between the superconducting channel and the substrate, the superconducting current flows across the entire cross section of the superconducting thin film.

For this purpose, the oxide layers are preferably composed of high crystallinity in which one to five unitcells of crystalline lattices are stacked. The oxide layer which is composed of the incomplete crystal lattices does not have the effect. However, if the oxide layer between the superconducting channel and the gate insulator is too thick, it is difficult to control the superconducting current by applying a voltage to the gate electrode.

Since the gate insulator is formed of SrTiO₃, MgO, etc., it is difficult to form the gate insulator having a relatively thin thickness. Therefore, the oxide layer between the superconducting channel and the gate insulator may not be formed too thick. In this connection, SrOₓ, BaOₓ, KOₓ and PbOₓ are favorable, since they have smaller lattice parameters than Pr₁Ba₂Cu₃O_{7-ε}.

In the superconducting device in accordance with the present invention, the oxide layer between the superconducting channel and the substrate absorbs the stress which is generated by thermal expansion coefficient discrepancy between the superconducting channel and the substrate. Substrate constituent atoms diffusion is also confined in the oxide layer between the superconducting channel and the substrate so that the superconducting channel is prevented from losing superconductivity.

For these purpose, the oxide layer between the superconducting channel and the substrate preferably has a thickness almost same as that of superconducting channel. The oxide layer formed of a *c*-axis orientated Pr₁Ba₂Cu₃O_{7-ε} thin film is favorable, since a Pr₁Ba₂Cu₃O_{7-ε} crystal lattice tends to be deformed along *a*-axis of the crystal lattice.

In a preferred embodiment, the oxide superconductor is formed of high-T_{c} (high critical temperature) oxide superconductor, particularly, formed of a high-T_{c} copper-oxide type compound oxide superconductor for example a Y-Ba-Cu-O compound oxide superconductor material, a Bi-Sr-Ca-Cu-O compound oxide superconductor material, and a Tl-Ba-Ca-Cu-O compound oxide superconductor material.

In addition, the substrate can be formed of an insulating substrate, preferably an oxide single crystalline substrate such as MgO, SrTiO₃, CdNdAlO₄, etc. These substrate materials are very effective in forming or growing a crystalline film having a high degree of crystalline orientation. However, the superconducting device can be formed on a semiconductor substrate if an appropriate buffer layer is deposited thereon. For example, the buffer layer on the semiconductor substrate can be formed of a double-layer coating formed of a MgAlO₄ layer and a BaTiO₃ layer if silicon is used as a substrate.

Preferably, the superconducting channel is formed of a *c*-axis orientated oxide superconductor thin film and the superconducting source electrode and the superconducting drain electrode are formed of *a*-axis orientated oxide superconductor thin films.

According to the method of the present invention as set forth in claim 15, the oxide layer or layers and the superconducting channel are continuously formed by MBE. With this, the oxide layer or layers and the superconducting channel are of high crystallinity and interfaces are formed sharply.

In order to form the oxide layer or layers and the superconducting channel continuously, all of the necessary molecular beam sources are prepared, at the beginning. Thin films which compose the oxide layer or layers and the superconducting channel are continuously deposited by exchanging the molecular beam sources.

In order to exchange molecular beam sources accurately and in order to form the thin films having precisely determined thickness, the thin film surfaces are preferably monitored by RHEED (respective high energy electron diffraction), while the thin films are deposited.

The above and other objects, features and advantages of the present invention will be apparent from the following description of preferred embodiments of the invention with reference to the accompanying drawings.

### Brief Description of the drawings

Figures 1A to 1E are diagraminatic sectional views for illustrating a first embodiment of the process in accordance with the present invention for manufacturing the super-FET;
Figures 2A to 2D are diagrammatic sectional views for illustrating a second embodiment of the process in accordance with the present invention for manufacturing the super-FET; and
Figures 3A to 3F are diagrammatic sectional views for illustrating a third embodiment of the process in accordance with the present invention for manufacturing the super-FET.

### Description of the Preferred embodiments

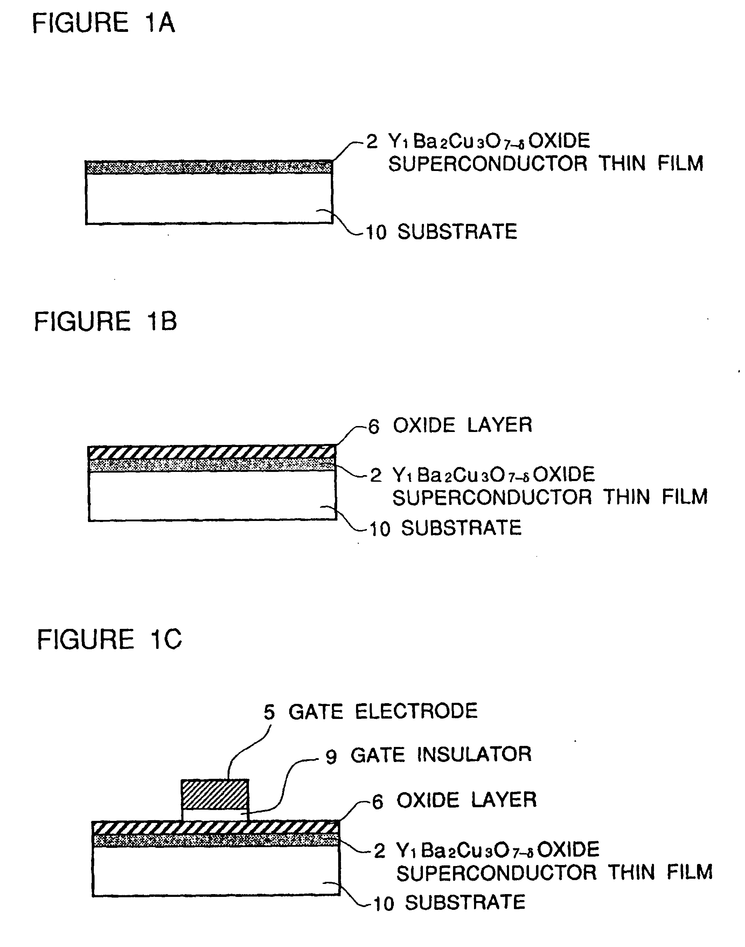

Referring to Figures 1A to 1E, the process in accordance with the present invention for manufacturing the super-FET will be described.

As shown in Figure 1A, a *c*-axis orientated Y₁Ba₂Cu₃O_{7-δ} oxide superconductor thin film 2 having a thickness on the order of about 5 nanometers is deposited on a principal surface of a MgO (100) single crystalline substrate 10, by an MBE. While the Y₁Ba₂Cu₃O_{7-δ} oxide superconductor thin film 2 is growing, the surface morphology of the Y₁Ba₂Cu₃O_{7-δ} oxide superconductor thin film 2 is monitored by RHEED so that the atomic layers which constitute the Y₁Ba₂Cu₃O_{7-δ} crystals are accurately stacked layer by layer or unit by unit.

The *c*-axis orientated Y₁Ba₂Cu₃O_{7-δ} oxide superconductor thin film 2 is composed of a *c*-axis orientated Y₁Ba₂Cu₃O_{7-δ} oxide superconductor crystalline layer in which five unit-cells of the crystalline lattices are stacked.

A condition of forming the *c*-axis orientated Y₁Ba₂Cu₃O_{7-δ} oxide superconductor thin film 2 by MBE is as follows:
- Molecular beam source: Y: 1250°C
Ba: 600°C
Cu: 1040°C
- Pressure: 1.33·10⁻⁵ hPa (1 × 10⁻⁵ Torr)
- Temperature of the substrate: 700°C

Then, the Y molecular beam source is switched to a Pr molecular beam source so that an oxide layer 6 composed of *c*-axis orientated Pr₁Ba₂Cu₃O_{7-ε} thin film having a thickness of about 1.2 nanometer is continuously formed on the Y₁Ba₂Cu₃O_{7-δ} oxide superconductor thin film 2, as shown in Figure 1B. The *c*-axis orientated Pr₁Ba₂Cu₃O_{7-ε} thin film is composed of a *c*-axis orientated Pr₁Ba₂Cu₃O_{7-ε} crystalline layer in which crystalline lattices are disposed to constitute one unitcell layer.

A condition of forming the *c*-axis orientated Pr₁Ba₂Cu₃O_{7-ε} oxide thin film by MBE is as follows:
- Molecular beam source: Pr: 1225°C
Ba: 600°C
Cu: 1040°C
- Pressure: 1.33·10⁻⁵ hPa (1 × 10⁻⁵ Torr)
- Temperature of the substrate: 700°C

As shown in Figure 1C, a gate insulator 9 and a gate electrode 5 are formed on a center portion of the oxide layer 6. The gate insulator 9 is formed of SrTiO₃ and has a thickness of 10 nanometers. The gate insulator is formed by etching a SrTiO₃ thin film which is deposited by a sputtering process. The gate electrode 5 is formed of Au by a vacuum evaporation.

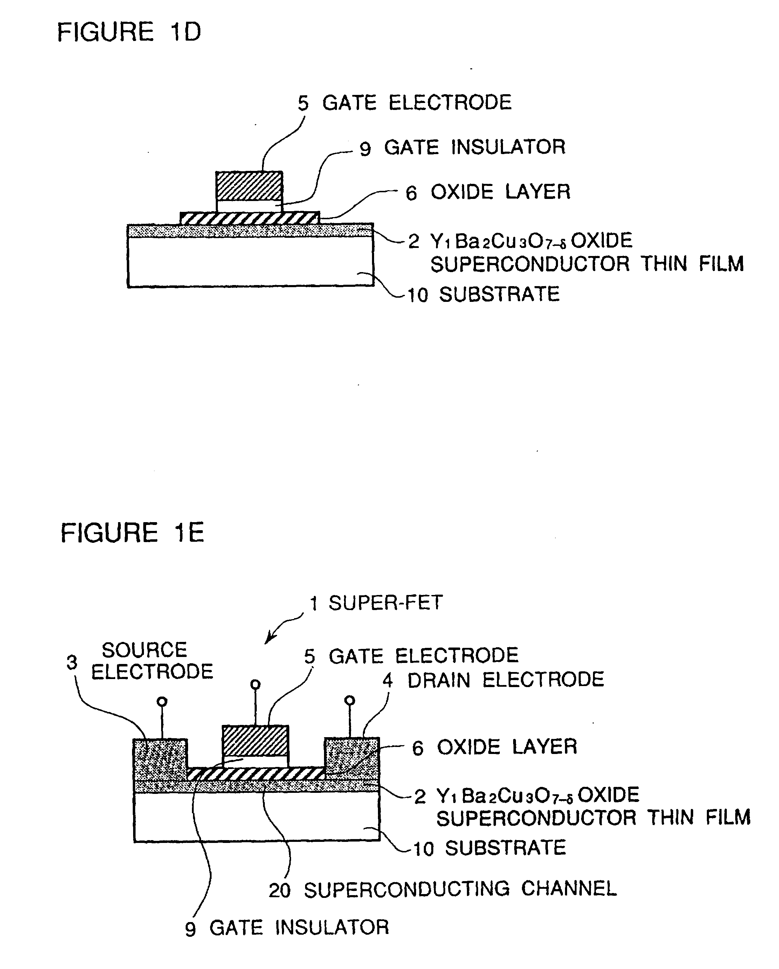

Thereafter, as shown in Figure 1D, the oxide layer 6 is selectively etched so as to remove all of the oxide layer excluding a center portion by means of an anisotropic etching, so that the Y₁Ba₂Cu₃O_{7-δ} oxide superconductor thin film 2 are exposed at the etched portion. This etching process is carried out by a reactive ion etching process or an ion milling using An-ions.

Finally, as shown in Figure 1E, a superconducting source electrode 3 and a superconducting drain electrode 4 of an *a*-axis orientated Y₁Ba₂Cu₃O_{7-δ} oxide superconductor thin film are formed on the exposed portions of the Y₁Ba₂Cu₃O_{7-δ} oxide superconductor thin film 2 at both sides of the oxide layer 6, respectively. An *a*-axis orientated Y₁Ba₂Cu₃O_{7-δ} oxide superconductor thin film can be formed by an MBE process which is carried out under a condition that the substrate temperature is not higher than 650°C. An MBE condition under which the superconducting source electrode 3 and the superconducting drain electrode 4 are formed is as follows:
- Molecular beam source: Y: 1250°C
Ba: 600°C
Cu: 1040°C
- Pressure: 1.33·10⁻⁵ hPa (1 × 10⁻⁵ Torr)
- Temperature of the substrate: 640°C

A metal source electrode and a metal drain electrode may be formed on the superconducting source electrode 3 and the superconducting drain electrode 4 respectively, if necessary. With this, the super-FET in accordance with the present invention is completed.

The above mentioned super-FET manufactured in accordance with the first embodiment of the method of the present invention has a superconducting channel of which the superconducting current flows in a layer having a thickness of at least three unitcells of Y₁Ba₂Cu₃O_{7-δ} oxide superconductor crystal lattices from the upper surface. Therefore, the substantial cross-sectional area of the superconducting channel of the super-FET is lager than that of a conventional super-FET. By this, the current capability of the super-FET can be improved.

Required voltage which is applied to the gate electrode in order to shunt the superconducting channel of the super-FET is 20 volts, which is little higher than that of a conventional super-FET. Since the oxide layer 6 is continuously formed on the Y₁Ba₂Cu₃O_{7-δ} oxide superconductor thin film 2, the surface of the Y₁Ba₂Cu₃O_{7-δ} oxide superconductor thin film 2 is not degraded so that the interface between the Y₁Ba₂Cu₃O_{7-δ} oxide superconductor thin film 2 and the oxide layer 6 is formed sharply. Accordingly, the super-FET has a stable performance and large current capability.

Other super-FETs in accordance with the present invention, of which the oxide layers are composed of SrOₓ, BaOₓ, KOₓ or PbOₓ instead of Pr₁Ba₂Cu₃O_{7-ε} are manufactured by a similar process as mentioned above. Since crystal unit sizes of these oxide are smaller than that of Pr₁Ba₂Cu₃O_{7-ε,} the oxide layer 6 can be formed thinner so that the applied voltage which is required to shunt the channel can be lowered.

These super-FETs are manufactured by almost same method as the above mentioned method. Therefore, the difference will be described in the following.

When the super-FET which utilizes SrOₓ for the oxide layer 6 is manufactured, in order to form the oxide layer 6, the Y molecular beam source, the Ba molecular beam source and the Cu molecular beam source are shut and the Sr molecular beam source is opened in the process shown in Figure 1B. Similar operations are carried out in case of the super-FETs utilizing KOₓ or PbOₓ for the oxide layer 6. In case of BaOₓ, the Y molecular beam source and the Cu molecular beam source are shut and only the Ba molecular beam source is kept open. Conditions of forming the SrOₓ oxide thin film, BaOₓ oxide thin film, KOₓ oxide thin film and PbOₓ oxide thin film by MBE are as follows:
SrOₓ

- Molecular beam source: Sr: 580°C
- Pressure: 1.33·10⁻⁵ hPa (1 × 10⁻⁵ Torr)
- Temperature of the substrate: 700°C
BaOₓ

- Molecular beam source: Ba: 785°C
- Pressure: 1.33·10⁻⁵ hPa (1 × 10⁻⁵ Torr)
- Temperature of the substrate: 700°C
KOₓ

- Molecular beam source: K: 420°C
- Pressure: 1.33·10⁻⁵ hPa (1 × 10⁻⁵ Torr)
- Temperature of the substrate: 700°C
PbOₓ

- Molecular beam source: Pb: 855°C
- Pressure: 1.33·10⁻⁵ hPa (1 × 10⁻⁵ Torr)
- Temperature of the substrate: 700°C

Each of the above mentioned super-FETs in accordance with the present invention has superconducting channel of which the superconducting current flows in a layer having a thickness of at least three unitcells of Y₁Ba₂Cu₃O_{7-δ} oxide superconductor crystalline lattices from the upper surface. Therefore, the substantial cross-sectional area of the superconducting channels of the super-FETs are lager than that of a conventional super-FET. By this, the current capability of the super-FETs can be improved.

Required voltages which are applied to the gate electrodes in order to shunt the superconducting channels of the super-FETs are as follows:
SrOₓ

- Thickness of the oxide layer: 0.52 nanometers, 1unitcell
- Voltage for closing the gate: 12 volts
BaOₓ

- Thickness of the oxide layer: 0.55 nanometers, 1unitcell
- Voltage for closing the gate: 18 volts
KOₓ

- Thickness of the oxide layer: 0.65 nanometers, 1unitcell
- Voltage for closing the gate: 12 volts
PbOₓ

- Thickness of the oxide layer: 0.59 nanometers, 1unitcell
- Voltage for closing the gate: 12 volts

Both thickness of the oxide layers and required voltages for closing the gates of these super-FETs are smaller than those of the super-FET which utilizes Pr₁Ba₂Cu₃O_{7-ε} for the oxide layer 6. Therefore, these super-FETs are operated with lower gate voltages so that required power consumption becomes smaller.

Since the oxide layer 6 is formed successively on the Y₁Ba₂Cu₃O_{7-δ} oxide superconductor thin film 2, the surface of the Y₁Ba₂Cu₃O_{7-δ} oxide superconductor thin film 2 is not degraded so that the interface between the Y₁Ba₂Cu₃O_{7-ε} oxide superconductor thin film 2 and the oxide layer 6 is formed sharply. Accordingly, the super-FET has a stable performance and higher current capability.

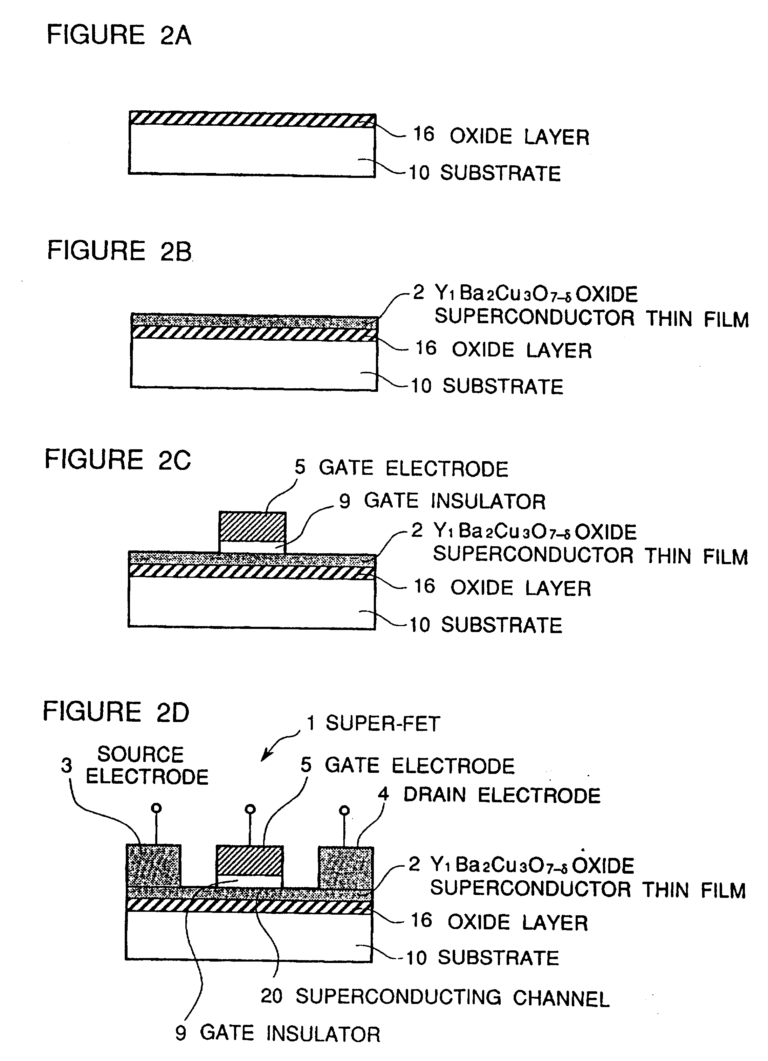

Referring to Figures 2A to 2D, a second embodiment of the process for manufacturing the superconducting device will be described.

As shown in Figure 2A, an oxide layer 16 composed of *c*-axis orientated Pr₁Ba₂Cu₃O_{7-ε} thin film having a thickness on the order of about 5 nanometers is deposited on a principal surface of a MgO (100) single crystalline substrate 10, by an MBE. While the Pr₁Ba₂Cu₃O_{7-ε} thin film 16 is growing, the surface morphology of the Y₁Ba₂Cu₃O_{7-ε} thin film 16 is monitored by RHEED so that the atomic layers which constitute the Pr₁Ba₂Cu₃O₇₋ε crystals are accurately stacked layer by layer or unit by unit.

The *c*-axis orientated Pr₁Ba₂Cu₃O_{7-ε} thin film 16 is composed of a c-axis orientated Pr₁Ba₂Cu₃O_{7-ε} crystal layer in which five unitcells of the crystalline lattices are stacked.

A condition of forming the *c*-axis orientated Pr₁Ba₂Cu₃O_{7-ε} thin film by MBE is as follows:
- Molecular beam source: Pr: 1225°C
Ba: 600°C
Cu: 1040°C
- Pressure: 1.33·10⁻⁵ hPa (1 × 10⁻⁵ Torr)
- Temperature of the substrate: 700°C

Then, the Pr molecular beam source is exchanged to a Y molecular beam source so that a *c*-axis orientated Y₁Ba₂Cu₃O_{7-δ} oxide superconductor thin film 2 having a thickness of about 5 nanometer is continuously formed on the oxide layer 16 of Pr₁Ba₂Cu₃O_{7-ε} thin film, as shown in Figure 2B. The *c*-axis orientated Y₁Ba₂Cu₃O_{7-δ} oxide super conductor thin film 2 is composed of a *c*-axis orientated Y₁Ba₂Cu₃O_{7-δ} crystalline layer in which five unitcells of the crystalline lattices are stacked.

A condition of forming the *c*-axis orientated Y₁Ba₂Cu₃O_{7-δ} oxide superconductor thin film 2 by MDE is as follows:
- Molecular beam source: Y: 1250°C
Ba: 600°C
Cu: 1040°C
- Pressure: 1.33·10⁻⁵ hPa (1 × 10⁻⁵ Torr)
- Temperature of the substrate: 700°C

As shown in Figure 2C, a gate insulator 9 and a gate electrode 5 are formed on a center portion of the *c*-axis orientated Y₁Ba₂Cu₃O_{7-δ} oxide superconductor thin film 2. The gate insulator 9 is formed of SrTiO₃ and has a thickness of 10 nanometers. The gate insulator is formed by etching a SrTiO₃ thin film which is deposited by a sputtering process. The gate electrode 5 is formed of Au by a vacuum evaporation.

Finally, as shown in Figure 2D, a superconducting source electrode 3 and a superconducting drain electrode 4 of an *a*-axis orientated Y₁Ba₂Cu₃O_{7-δ} oxide superconductor thin film are formed on the Y₁Ba₂Cu₃O_{7-δ} oxide superconductor thin film 2 at both sides of the gate insulator 9 and the gate electrode 5, respectively. An *a*-axis orientated Y₁Ba₂Cu₃O_{7-δ} oxide superconductor thin film can be formed by an MBE process which is carried out under a condition that the substrate temperature is not higher than 650°C. An MBE condition under which the superconducting source electrode 3 and the superconducting drain electrode 4 are formed is same as the first embodiment.

A metal source electrode and a metal drain electrode may be formed on the superconducting source electrode 3 and the superconducting drain electrode 4 respectively, if necessary. With this, the super-FET in accordance with the present invention is completed.

The above mentioned super-FET manufactured in accordance with the second embodiment of the method of the present invention has a superconducting channel of which the superconducting current flows in a layer having a thickness of at least three unitcells of Y₁Ba₂Cu₃O_{7-δ} oxide superconductor crystalline lattices from the bottom surface. Therefore, the substantial cross-sectional area of the superconducting channel of the super-FET is larger than that of a conventional super-FET. By this, the current capability of the super-FET can be improved.

Since the Y₁Ba₂Cu₃O_{7-δ} oxide superconductor thin film 2 is formed on the oxide layer 16, the stress which is generated by thermal expansion coefficient discrepancy between the Y₁Ba₂Cu₃O_{7-δ} oxide superconductor and the MgO substrate is absorbed by the oxide layer 16 so that the Y₁Ba₂Cu₃O_{7-δ} oxide superconductor thin film 2 is not stressed. Additionally, the Y₁Ba₂Cu₃O_{7-δ} oxide superconductor thin film 2 is continuously formed on the oxide layer 16 so that the interface between the Y₁Ba₂Cu₃O_{7-δ} oxide superconductor thin film 2 and the oxide layer 6 is formed sharply. Accordingly, the super-FET has a stable performance and higher current capability.

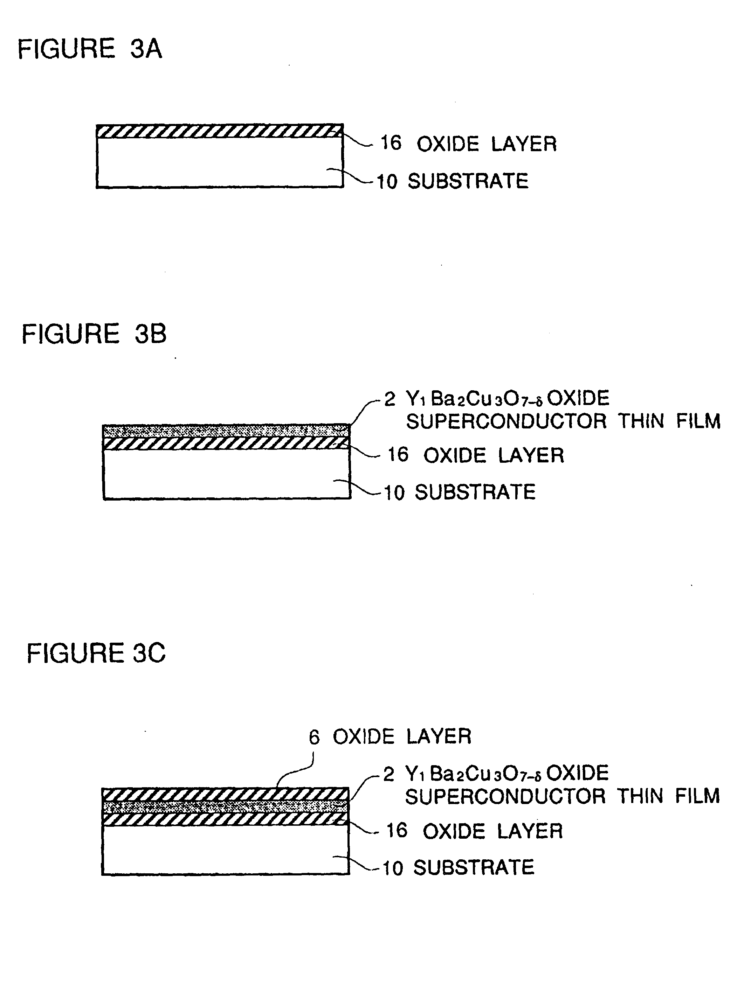

Referring to Figures 3A to 3F, a third embodiment of the process for manufacturing the superconducting device will be described.

As shown in Figure 3A, an oxide layer 16 composed of *c*-axis orientated Pr₁Ba₂Cu₃O_{7-ε} thin film having a thickness on the order of about 5 nanometers is deposited on a principal surface of a MgO (100) single crystalline substrate 10, by an MBE. While the Pr₁Ba₂Cu₃O_{7-ε} thin film 16 is growing, the surface morphology of the Pr₁Ba₂Cu₃O_{7-ε} thin film 16 is monitored by RHEED so that the atomic layers which constitute the Pr₁Ba₂Cu₃O_{7-ε} crystals are accurately stacked layer by layer or unit by unit.

The *c*-axis orientated Pr₁Ba₂Cu₃O_{7-ε} thin film 16 is composed of a *c*-axis orientated Pr₁Ba₂Cu₃O_{7-ε} crystal layer in which five unitcells of the crystalline lattices are stacked.

A condition of forming the *c*-axis orientated Pr₁Ba₂Cu₃O_{7-ε} thin film by MBE is same as the second embodiment.

Then, the Pr molecular beam source is exchanged to a Y molecular beam source so that a *c*-axis orientated Y₁Ba₂Cu₃O_{7-δ} oxide superconductor thin film 2 having a thickness of about 5 nanometer is continuously formed on the oxide layer 16 of Pr₁Ba₂Cu₃O_{7-ε} thin film, as shown in Figure 3B. The *c*-axis orientated Y₁Ba₂Cu₃O_{7-δ} oxide super conductor thin film 2 is composed of a *c*-axis orientated Y₁Ba₂Cu₃O_{7-δ} crystalline layer in which five unitcells of the crystalline lattices are stacked.

A condition of forming the *c*-axis orientated Y₁Ba₂Cu₃O_{7-δ} oxide superconductor thin film 2 by MBE is same as the second embodiment.

Thereafter, the Y molecular beam source is exchanged to a Pr molecular beam source again so that an oxide layer 6 composed of *c*-axis orientated Pr₁Ba₂Cu₃O_{7-ε} thin film having a thickness of about 1.2 nanometer is continuously formed on the Y₁Ba₂Cu₃O_{7-δ} oxide superconductor thin film 2, as shown in Figure 3C. The *c*-axis orientated Pr₁Ba₂Cu₃O_{7-ε} thin film is composed of a *c*-axis orientated Pr₁Ba₂Cu₃O_{7-ε} crystalline layer in which crystalline lattices are disposed to constitute one unitcell layer.

A condition of forming the *c*-axis orientated Pr₁Ba₂Cu₃O_{7-ε} oxide thin film by MBE is same as the first embodiment.

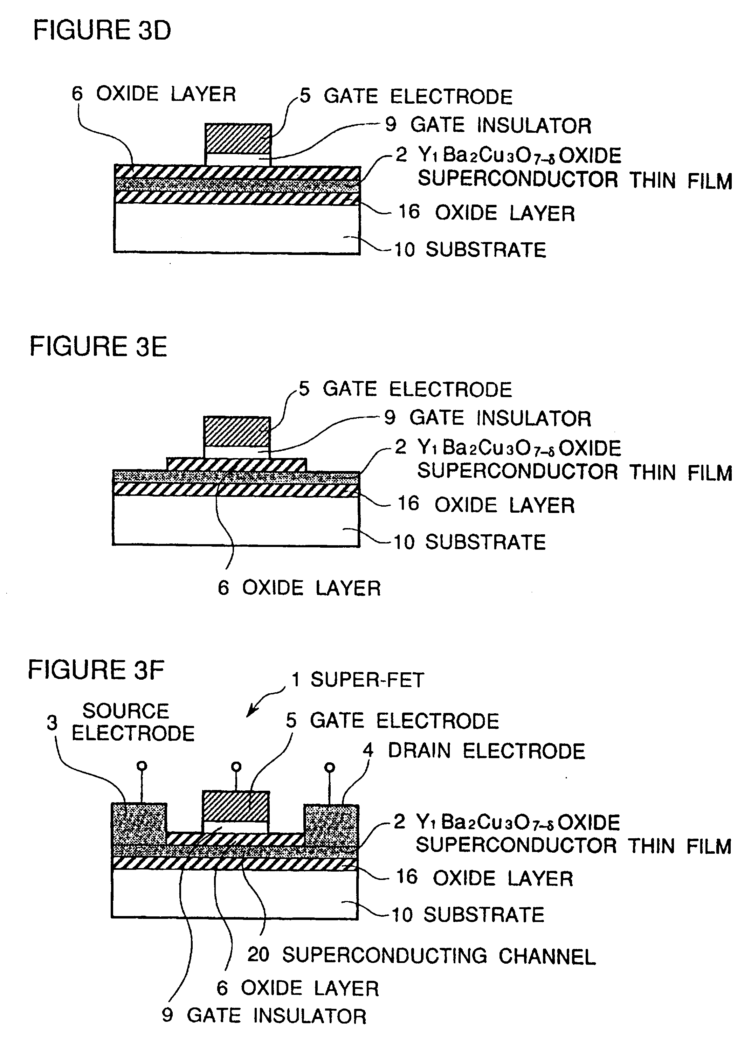

As shown in Figure 3D, a gate insulator 9 and a gate electrode 5 are formed on a center portion of the oxide layer 6. The gate insulator 9 is formed of SrTiO₃ and has a thickness of 10 nanometers. The gate insulator is formed by etching a SrTiO₃ thin film which is deposited by a sputtering process. The gate electrode 5 is formed of Au by a vacuum evaporation.

Thereafter, as shown in Figure 3E, the oxide layer 6 is selectively etched so as to remove all of the oxide layer excluding a center portion by means of an anisotropic etching, so that the Y₁Ba₂Cu₃O_{7-δ} oxide superconductor thin film 2 are exposed at the etched portion. This etching process is carried out by a reactive ion etching process or an ion milling using Ar-ions.

Finally, as shown in Figure 3F, a superconducting source electrode 3 and a superconducting drain electrode 4 of an *a*-axis orientated Y₁Ba₂Cu₃O_{7-δ} oxide superconductor thin film are formed on the exposed portions of the Y₁Ba₂Cu₃O_{7-δ} oxide superconductor thin film 2 at both sides of the oxide layer 6, respectively. An *a*-axis orientated Y₁Ba₂Cu₃O_{7-δ} oxide superconductor thin film can be formed by an MBE process which is carried out under a condition that the substrate temperature is not higher than 650°C. An MBE condition under which the superconducting source electrode 3 and the superconducting drain electrode 4 are formed is same as the first embodiment.

A metal source electrode and a metal drain electrode may be formed on the superconducting source electrode 3 and the superconducting drain electrode 4 respectively, if necessary. With this, the super-FET in accordance with the present invention is completed.

The above mentioned super-FET manufactured in accordance with the third embodiment of the method of the present invention has a superconducting channel of which the superconducting current flows across the entire cross section. Therefore, the substantial cross-sectional area of the superconducting channel of the super-FET is lager than that of a conventional super-FET. By this, the current capacity of the super-FET can be improved.

Required voltage which is applied to the gate electrode in order to shunt the superconducting channel of the super-FET is 20 volts, which is little higher than that of a conventional super-FET. Since the Y₁Ba₂Cu₃O_{7-δ} oxide superconductor thin film 2 is formed on the oxide layer 16, the stress which is generated by the thermal expansion coefficient discrepancy between the Y₁Ba₂Cu₃O_{7-δ} oxide superconductor and the MgO substrate is absorbed by the oxide layer 16 so that the Y₁Ba₂Cu₃O_{7-δ} oxide superconductor thin film 2 is not stressed. Further more, since the Y₁Ba₂Cu₃O_{7-δ} oxide superconductor thin film 2 is continuously formed on the oxide layer 16 and the oxide layer 6 is continuously formed on the Y₁Ba₂Cu₃O_{7-δ} oxide superconductor thin film 2, the upper and bottom surfaces of the Y₁Ba₂Cu₃O_{7-δ} oxide superconductor thin film 2 are not degraded so that the interfaces between the oxide layer 16 and the Y₁Ba₂Cu₃O_{7-δ} oxide superconductor thin film 2 and between the Y₁Ba₂Cu₃O_{7-δ} oxide superconductor thin film 2 and the oxide layer 6 are formed sharply. Accordingly, the super-FET has a stable performance and higher current capability.

Other super-FETs in accordance with the present invention, of which the oxide layers are composed of SrOₓ, BaOₓ, KOₓ or PbOₓ instead of Pr₁Ba₂Cu₃O_{7-ε} are manufactured by the above mentioned process. Since crystalline unit sizes of these oxide are smaller than that of Pr₁Ba₂Cu₃O_{7-ε}, the oxide layer 6 can be formed thinner so that the applied voltage which is required to shunt the superconducting channel, can be lowered.

These super-FETs are manufactured by almost same method as the above mentioned method. Therefore, the difference will be described in the following.

When the super-FET which utilizes SrOₓ for the oxide layer 6 is manufactured, in order to form the oxide layer 6, the Y molecular beam source, the Ba molecular beam source and the Cu molecular beam source are shut and the Sr molecular beam source is opened in the process shown in Figure 3C. Similar operations are carried out in case of the super-FETs utilizing KOₓ or PbOₓ for the oxide layer 6. In case of BaOₓ, the Y molecular beam source and the Cu molecular beam source are shut and only the Ba molecular beam source is kept open. Conditions of forming the SrOₓ oxide thin film, BaOₓ oxide thin film, KOₓ oxide thin film and PbOₓ oxide thin film by MBE are same as the first embodiment.

Each of the above mentioned super-FETs in accordance with the present invention has a superconducting channel of which the superconducting current flows across the entire cross section. Therefore, the substantial cross-sectional area of the superconducting channels of the super-FETs are lager than that of a conventional super-FET. By this, the current capability of the super-FETs can be improved.

Required voltages which are applied to the gate electrodes in order to shunt the superconducting channels of the super-FETs are as follows:
SrOₓ

- Thickness of the oxide layer: 0.52 nanometers, 1unitcell
- Voltage for closing the gate: 12 volts
BaOₓ

- Thickness of the oxide layer: 0.55 nanometers, 1unitcell
- Voltage for closing the gate: 18 volts
KOₓ

- Thickness of the oxide layer: 0.65 nanometers, 1unitcell
- Voltage for closing the gate: 12 volts
PbOₓ

- Thickness of the oxide layer: 0.59 nanometers, 1unitcell
- Voltage for closing the gate: 12 volts

Both thickness of the oxide layers arid required voltages for closing the gates of these super-FETs are smaller than those of the super-FET which utilizes Pr₁Ba₂Cu₃O_{7-ε} for the oxide layer 6. Therefore, these super-FETs are operated with lower gate voltages so that required power consumption becomes smaller.

Since the Y₁Ba₂Cu₃O_{7-δ} oxide superconductor thin film 2 is continuously formed on the oxide layer 16 and the oxide layer 6 is continuously formed on the Y₁Ba₂Cu₃O_{7-δ} oxide superconductor thin film 2, the upper and bottom surfaces of the Y₁Ba₂Cu₃O_{7-δ} oxide superconductor thin film 2 are not degraded so that the interfaces between the oxide layer 16 and the Y₁Ba₂Cu₃O_{7-δ} oxide superconductor thin film 2 and between the Y₁Ba₂Cu₃O_{7-δ} oxide superconductor thin film 2 and the oxide layer 6 are formed sharply. Accordingly, the super-FET has a stable performance and higher current capability.

In the above mentioned embodiments, the oxide superconductor thin film can be formed of not only the Y-Ba-Cu-O compound oxide superconductor material, but also a high-T_{c} (high critical temperature) oxide superconductor material, particularly a high-T_{c} copper-oxide type compound oxide superconductor material, for example a Bi-Sr-Ca-Cu-O compound oxide superconductor material, and a Tl-Ba-Ca-Cu-O compound oxide superconductor material.

The invention has thus been shown and described with reference to the specific embodiments. However, it should be noted that the present invention is in no way limited to the details of the illustrated structures but converts and modifications may be made within the scope of the appended claims.

## Claims

1. A superconducting device comprising a substrate (10), a superconducting channel (20) formed of an oxide superconductor thin film (2) over the substrate (10), a superconducting source electrode (3) and a superconducting drain electrode (4) formed of an oxide superconductor on the oxide superconductor thin film (2) separated from each other but electrically connected by the superconducting channel (20), and a gate electrode (5) formed on a gate insulator (9) over the superconducting channel (20) for controlling the superconducting current flowing through the superconducting channel (20),
**characterized in that** the superconducting device further comprises an oxide layer or oxide layers (6, 16) between the superconducting channel (20) and the gate insulator (9) and/or between the substrate (10) and the superconducting channel (20), the superconducting channel (20) is formed of a *c*-axis orientated oxide superconductor thin film (2), the superconducting source electrode (3) and the superconducting drain electrode (4) are formed of *a*-axis orientated oxide superconductor thin films.

2. A superconducting device claimed in Claim 1 **characterized in that** the superconducting device comprises said oxide layer (6) only between the superconducting channel (20) and the gate insulator (9).

3. A superconducting device claimed in Claim 1 **characterized in that** the superconducting device comprises said oxide layer (16) only between the superconducting channel (20) and the substrate (10).

4. A superconducting device claimed in Claim 1 **characterized in that** the superconducting device comprises both of said oxide layers (6, 16) between the superconducting channel (20) and the gate insulator (9) and between the superconducting channel (20) and the substrate (10).

5. A superconducting device claimed in Claim 1, 3 or 4 **characterized in that** said oxide layer (16) between the superconducting channel (20) and the substrate (10) is formed of a *c*-axis orientated Pr₁Ba₂Cu₃O_{7-ε} thin film.

6. A superconducting device claimed in Claim 1, 2, or 4 **characterized in that** said oxide layer (6) between the superconducting channel (20) and the gate insulator (9) is formed of a *c*-axis orientated Pr₁Ba₂Cu₃O_{7-ε} thin film, an SrOₓ thin film, a BaOₓ thin film, a KOₓ thin film or a PbOₓ thin film.

7. A superconducting device claimed in Claim 4 **characterized in that** both of said oxide layers (6, 16) are formed of *c*-axis orientated Pr₁Ba₂Cu₃O_{7-ε} thin films.

8. A superconducting device claimed in Claim 4 **characterized in that** said oxide layer (16) between the superconducting channel (20) and the substrate (10) is formed of a *c-*axis orientated Pr₁Ba₂Cu₃O_{7-ε} thin film and said oxide layer (6) between the superconducting channel (20) and the gate insulator (9) is formed of an SrOₓ thin film, a BaOₓ thin film, a KOₓ thin film or a PbOₓ thin film.

9. A superconducting device claimed in anyone of Claims 1, 3, 4, 5, 7 and 8 **characterized in that** the oxide layer (16) between the superconducting channel (20) and the substrate (10) has a thickness which is almost the same as that of the superconducting channel (20).

10. A superconducting device claimed in anyone of Claims 1, 2, 4 and 6 to 8 **characterized in that** the oxide layer (6) between the superconducting channel (20) and the gate insulator (9) is composed of the oxide crystal layer in which one to five unitcells of crystalline lattices are stacked.

11. A superconducting device claimed in anyone of Claims 1 to 10 **characterized in that** the oxide superconductor is formed of high-T_{c} (high critical temperature) oxide superconductor, particularly, formed of a high-T_{c} copper-oxide type compound oxide superconductor.

12. A superconducting device claimed in Claim 11 **characterized in that** the oxide superconductor is formed of oxide superconductor material selected from the group consisting of a Y-Ba-Cu-O compound oxide superconductor material, a Bi-Sr-Ca-Cu-O compound oxide superconductor material, and a Tl-Ba-Ca-Cu-O compound oxide superconductor material.

13. A superconducting device claimed in anyone of Claims 1 to 12 **characterized in that** the substrate is formed of a material selected from the group consisting of a MgO (100) substrate, a SrTiO₃ (100) substrate and a CdNdAlO₄ (001) substrate, and a semiconductor substrate.

14. A superconducting device claimed in Claim 14 **characterized in that** the substrate is formed of a silicon substrate and a principal surface of the silicon substrate is coated with an insulating material layer which is formed of a MgAl₂O₄ layer and a BaTiO₃ layer.

15. A method of manufacturing a superconducting device as claimed in any of the preceding claims comprising a substrate (10), a superconducting channel (20) formed of an oxide superconductor thin film (2) over the substrate (10), a superconducting source electrode (3) and a superconducting drain electrode (4) formed of an oxide superconductor on the oxide superconductor thin film (2) separated from each other but electrically connected by the superconducting channel (20), a gate electrode (5) formed on a gate insulator (9) over the superconducting channel (20) for controlling the superconducting current flowing through the superconducting channel (20), and a first oxide layer (6) between the superconducting channel (20) and the gate insulator (9) and/or a second oxide layer (16) between the superconducting channel (20) and the substrate (10), **characterized in that** the method comprises steps of depositing the first oxide layer (6) and/or the second oxide layer (16) and the oxide superconductor thin film (2) continuously by MBE by switching molecular beam sources so as to prevent degradation of a surface of the second oxide layer (16) and/or the oxide superconductor thin film (2) to form a sharp interface or interfaces between the oxide superconductor thin film (2) and the first oxide layer (6) and/or between the oxide superconductor thin film (2) and the second oxide layer (16).

## Patentansprüche

1. Supraleitende Einrichtung mit einem Substrat (10), mit einem supraleitenden Kanal (20) aus einer oxydischen supraleitenden Dünnschicht (2) auf dem Substrat (10), mit einer supraleitenden Source-Elektrode (3) und mit einer supraleitenden Drainelektrode (4) aus einem oxydischen Supraleiter auf der supraleitenden Dünnschicht (2), die voneinander getrennt sind, jedoch elektrisch durch den supraleitenden Kanal (20) miteinander verbunden sind und mit einer Gate-Elektrode (5) auf einem Gate-Isolator (9) auf dem supraleitenden Kanal (20) zur Steuerung des durch den supraleitenden Kanal (20) fließenden Supraleitungsstromes, dadurch gekennzeichnet, daß die supraleitende Einrichtung außerdem eine Oxydschicht oder Oxydschichten (6, 16) aufweist zwischen dem supraleitenden Kanal (20) und dem Gate-Isolator (9) und/oder zwischen dem Substrat (10) und dem supraleitenden Kanal (20), daß der supra-leitende Kanal (20) aus einer oxydischen supraleitenden Dünnschicht (2) mit c-Achs-Ausrichtung besteht und daß die supraleitende Source-Elektrode (3) und die supraleitende Drain-Elektrode (4) aus oxydischen supraleitenden Dünnschichten mit a-Achs-Ausrichtung bestehen.

2. Supraleitende Einrichtung nach Anspruch 1, dadurch gekennzeichnet, daß die supraleitende Einrichtung die Oxydschicht (6) nur zwischen dem supraleitenden Kanal (20) und dem Gate-Isolator (9) aufweist.

3. Supraleitende Einrichtung nach Anspruch 1, dadurch gekennzeichnet, daß die supraleitende Einrichtung die Oxydschicht (16) nur zwischen dem supraleitenden Kanal (20) und dem Substrat (10) aufweist.

4. Supraleitende Einrichtung nach Anspruch 1, dadurch gekennzeichnet, daß die supraleitende Einrichtung beide Oxydschichten (6, 16) zwischen dem supraleitenden Kanal (20) und dem Gate-Isolator (9) sowie zwischen dem supraleitenden Kanal (20) und dem Substrat (10) aufweist.

5. Supraleitende Einrichtung nach Anspruch 1, 3 oder 4, dadurch gekennzeichnet, daß die Oxydschicht (16) zwischen dem supraleitenden Kanal (20) und dem Substrat (10) aus einer Pr₁Ba₂Cu₃O_{7-ε}-Dünnschicht mit c-Achs-Ausrichtung besteht.

6. Supraleitende Einrichtung nach Anspruch 1, 2 oder 4, dadurch gekennzeichnet, daß die Oxydschicht (6) zwischen dem supraleitenden Kanal 20 und dem Gate-Isolator (9) ads einer Pr₁Ba₂Cu₃O_{7-ε}-Dünnschicht mit c-Achs-Ausrichtung aus, einer SrOₓ-Dünnschicht, aus einer BaOₓ-Dünnschicht, aus einer KOₓ-Dünnschicht oder aus einer PbOₓ-Dünnschicht besteht.

7. Supraleitende Einrichtung nach Anspruch 4, dadurch gekennzeichnet, daß beide Oxydschichten (6, 16) aus Pr₁Ba₂Cu₃O_{7-ε}-Dünnschichten mit c-Achs-Ausrichtung bestehen.

8. Supraleitende Einrichtung nach Anspruch 4, dadurch gekennzeichnet, daß die Oxydschicht (16) zwischen dem supraleitenden Kanal (20) und dem Substrat (10) aus einer Pr₁Ba₂Cu₃O_{7-ε}-Dünnschicht mit c-Achs-Ausrichtung besteht und daß die Oxydschicht (6) zwischen dem supraleitenden Kanal (20) und dem Gate-Isolator (9) aus einer SrOₓ-Dünnschicht, einer BaOₓ-Dünnschicht, einer KOₓ-Dünnschicht oder einer PbOₓ-Dünnschicht besteht.

9. Supraleitende Einrichtung nach einem der Ansprüche 1, 3, 4, 5, 7 und 8, dadurch gekennzeichnet, daß die Oyxdschicht (16) zwischen dem supraleitenden Kanal 20 und dem Substrat (10) eine Dicke aufweist, welche fast die gleiche ist, wie diejenige des supraleitenden Kanals (20).

10. Supraleitende Einrichtung nach einem der Ansprüche 1, 2, 4 und 6 bis 8, dadurch gekennzeichnet, daß die Oxydschicht (6) zwischen dem supraleitenden Kanal (20) und dem Gate-Isolator (9) aus einer oxydischen Kristallschicht besteht, in welcher eine bis fünf Einheitszellen des kristallinen Gitters übereinander geschichtet sind.

11. Supraleitende Einrichtung nach einem der Ansprüche 1 bis 10, dadurch gekennzeichnet, daß der oxydische Supraleiter aus einem oxydischen Supraleiter hoher Tc (hoher kritischer Temperatur) besteht und insbesondere aus einem oxydischen Supraleiter aus einem Kupfer-Verbund-Oxyd mit hoher Tc.

12. Supraleitende Einrichtung nach Anspruch 11, dadurch gekennzeichnet, daß der oxydische Supraleiter aus einem oxydischen supraleitenden Material besteht, das ausgewählt ist aus der Gruppe bestehend aus dem supraleitenden Y-Ba-Cu-O-Verbund-Oxyd, dem supraleitenden Bi-Sr-Ca-Cu-O-Verbund-Oxyd und dem supraleitden Tl-Ba-Ca-Cu-O-Verbund-Oxyd.

13. Supraleitende Einrichtung nach einem der Ansprüche 1 bis 12, dadurch gekennzeichnet, daß das Substrat aus einem Material besteht, das ausgewählt ist aus der Gruppe bestehend aus einem MgO (100)-Substrat, einem SrTiO₃ (100)-Substrat, einem CdNdAlO₄ (001)-Substrat und einem Halbleiter-Substrat.

14. Supraleitende Einrichtung nach Anspruch 14, dadurch gekennzeichnet, daß das Substrat aus einem Silicium-Substrat besteht und daß eine Hauptoberfläche des Silicium-Substrats beschichtet ist mit einer isolierenden Material-Schicht, welche aus einer MgAl₂O₄-Schicht und einer BaTiO₃-Schicht besteht.

15. Verfahren zur Herstellung einer supraleitenden Einrichtung nach einem der vorhergehenden Ansprüche, mit einem Substrat (10), mit einem supraleitenden Kanal (20) aus einer oxydischen supraleitenden Dünnschicht (2) auf dem Substrat (10), mit einer supraleitenden Source-Elektrode (3) und mit einer supraleitenden Drain-Elektrode (4) aus einem oxydischen Supraleiter auf der oxydischen supraleitenden Dünnschicht 2, die voneinander getrennt sind, jedoch elektrisch durch den supraleitenden Kanal (20) miteinander verbunden sind, mit einer Gate-Elektrode (5) auf einem Gate-Isolator (9) auf dem supraleitenden Kanal (20) zur Steuerung des durch den supraleitenden Kanal (20) fließenden Supraleitungsstromes und mit einer ersten Oxydschicht (6) zwischen dem supraleitenden Kanal (20) und dem Gate-Isolator (9) und/oder einer zweiten Oxydschicht (16) zwischen dem supraleitenden Kanal (20) und dem Substrat (10), dadurch gekennzeichnet, daß das Verfahren die Schritte aufweist des Abscheidens der ersten Oxydschicht (6) und/oder der zweiten Oxydschicht (16) und der oxydischen supraleitenden Dünnschicht (2) kontinuierlich durch die MBE durch Umschalten von Molekularstrahlquellen, um so eine Beeinträchtigung der Oberfläche der zweiten Oxydschicht (16) und/oder der oxydischen supraleitenden Dünnschicht (2) zu verhindern und um einen scharfen Übergang oder Übergänge zwischen der oxydischen supraleitenden Dünnschicht (2) und der ersten Oxydschicht (6) und/oder zwischen der oxydischen supraleitenden Dünnschicht (2) und der zweiten Oxydschicht (16) zu erhalten.

## Revendications

1. Dispositif supraconducteur comprenant un substrat (10), un canal supraconducteur (20) formé d'un film mince d'oxyde supraconducteur (2) sur le substrat (10), une électrode de source supraconductrice (3) et une électrode de drain supraconductrice (4) formées d'un d'oxyde supraconducteur sur le film mince de d'oxyde supraconducteur (2) séparées l'une de l'autre mais connectées électriquement par le canal supraconducteur (20) et une électrode de grille (5) formée sur un isolateur de grille (9) au-dessus du canal supraconducteur (20) pour commander le courant supraconducteur circulant à travers le canal supraconducteur (20),
caractérisé en ce que le dispositif supraconducteur comprend de plus une couche d'oxyde ou des couches d'oxyde (6,16) entre le canal supraconducteur (20) et l'isolateur de grille (9) et/ou entre le substrat (10) et le canal supraconduteur (20) , le canal supraconducteur (20) est formé d'un film mince (2) d'oxyde supraconducteur orienté selon l'axe c , l'électode de source supraconductrice (3) et l'électrode de drain supraconductrice (4) sont formées de films minces d'oxyde supraconducteur orientés selon l'axe a.

2. Dispositif supraconducteur selon la revendication 1 caractérisé en ce que le dispositif supraconducteur comprend ladite couche d'oxyde (6) seulement entre le canal supraconducteur (20) et l'isolateur de grille (9).

3. Dispositif supraconducteur selon la revendication 1 caractérisé en ce que le dispositif supraconducteur comprend ladite couche d'oxyde (16) seulement entre le canal supraconducteur (20) et le substrat (10).

4. Dispositif supraconducteur selon la revendication 1 caractérisé en ce que le dispositif supraconducteur comprend les deux dites couches d'oxyde (6,16) entre le canal supraconducteur (20) et l'isolateur de grille (9) et entre le canal supraconducteur (20) et le substrat (10).

5. Dispositif supraconducteur selon la revendication 1, 3 ou 4 caractérisé en ce que ladite couche d'oxyde (16) entre le canal supraconducteur (20) et le substrat (10) est formée d'un film mince de Pr₁Ba₂Cu₃O_{7-ε} orienté selon l'axe c.

6. Dispositif supraconducteur selon la revendication 1, 2 ou 4, caractérisé en ce que ladite couche d'oxyde (6) entre le canal supraconducteur (20) et l'isolateur de grille (9) est formée d'un film mince de Pr₁Ba₂Cu₃O_{7-ε} orienté selon l'axe c, d'un film mince de SrOₓ , d'un film mince de BaOₓ , d'un film mince de KOₓ ou d'un film mince de PbOₓ.

7. Dispositif supraconducteur selon la revendication 4 caractérisé en ce que les deux dites couches d'oxyde (6,16) sont formées de films minces de Pr₁Ba₂Cu₃O_{7-ε} orientés selon l'axe c.

8. Dispositif supraconducteur selon la revendication 4 caractérisé en ce que ladite couche d'oxyde (16) entre le canal supraconducteur (20) et le substrat (10) est formée d'un film mince de Pr₁Ba₂Cu₃O_{7-ε} orienté selon l'axe c et ladite couche d'oxyde (6) entre le canal supraconducteur (20) et l'isolateur de grille (9) est formée d'un film mince de SrOₓ, d'un film mince de BaOₓ, d'un film mince de KOₓ ou d'un film mince de PbOₓ.

9. Dispositif supraconducteur selon l'une quelconque des revendications 1,3,4,5,7 et 8 caractérisé en ce que la couche d'oxyde (16) entre le canal supraconducteur (20) et le substrat (10) présente une épaisseur qui est presque la même que celle du canal supraconducteur (20).

10. Dispositif supraconducteur selon l'une quelconque des revendications 1, 2, 4 et 6 à 8, caractérisé en ce que la couche d'oxyde (6) entre le canal supraconducteur (20) et l'isolateur de grille (9) est composée de la couche cristalline d'oxyde dans laquelle une à cinq mailles élémentaires de réseaux cristallins sont empilées.

11. Dispositif supraconducteur selon l'une quelconque des revendications 1 à 10 caractérisé en ce que le supraconducteur d'oxyde est formé d'un supraconducteur d'oxyde à température critique élevée (Tc), particulièrement, formé d'un supraconducteur d'oxyde composé de type oxyde de cuivre à température critique élevée.

12. Dispositif supraconducteur selon la revendication 11 caractérisé en ce que le supraconducteur d'oxyde est formé d'un matériau en supraconducteur d'oxyde choisi dans le groupe constitué d'un matériau en supraconducteur d'oxyde composé Y-Ba-Cu-O , d'un matériau en supraconducteur d'oxyde composé Bi-Sr-Ca-Cu-O et d'un matériau en supraconducteur d'oxyde composé Tl-Ba-Ca-Cu-O.

13. Dispositif supraconducteur selon l'une quelconque des revendications 1 à 12 caractérisé en ce que le substrat est formé d'un matériau choisi à partir du groupe constitué d'un substrat de MgO (100), d'un substrat de SrTiO₃ (100) et d'un substrat de CdNdAlO₄ (001) et d'un substrat de semi-conducteur.

14. Dispositif supraconducteur selon la revendication 14 caractérisé en ce que le substrat est formé d'un substrat de silicium et une surface principale du substrat de silicium est recouverte d'une couche de matériau isolant qui est formée d'une couche de MgAl₂O₄ et d'une couche de BaTiO₃.

15. Procédé de fabrication d'un dispositif supraconducteur selon l'une quelconque des revendications précédentes comprenant un substrat (10), un canal supraconducteur (20) formé d'un film mince (2) d'oxyde supraconducteur sur le substrat (10), une électrode de source supraconductrice (3) et une électrode de drain supraconductrice (4) formées d'un supraconducteur d'oxyde sur le film mince (2) d'oxyde supraconducteur séparées l'une de l'autre mais connectées électriquement , par le canal supraconducteur (20), une électrode de grille (5) formée sur un isolateur de grille (9) au-dessus du canal supraconducteur (20) pour commander le courant supraconducteur circulant à travers le canal supraconducteur (20), et une première couche d'oxyde (6) entre le canal supraconducteur (20) et l'isolateur de grille (9) et/ou une seconde couche d'oxyde (16) entre le canal supraconducteur (20) et le substrat (10), caractérisée en ce que le procédé comprend les étapes consistant à déposer la première couche d'oxyde (6) et/ou la seconde couche d'oxyde (16) et le film mince (2) d'oxyde supraconducteur de façon continue par un procédé MBE en commutant des sources de faisceau moléculaire de façon à empêcher une dégradation de surface de la seconde couche d'oxyde (16) et/ou du film mince (2) d'oxyde supraconducteur pour former une interface ou des interfaces abrupte(s) entre le film mince (2) d'oxyde supraconducteur et la première couche d'oxyde (6) et/ou entre le film mince (2) d'oxyde supra-conducteur et la seconde couche d'oxyde (16).
